# EUROPEAN PATENT APPLICATION

(11) **EP 4 838 750 A1**
(43) Date of publication of application: **11.11.2026**
(21) Application number: 25873723.8
(22) Date of filing: 05.09.2025
(51) Int. Cl.: H02J 7/00, G01R 31/382, H01M 10/44

(54) **DEVICE AND METHOD FOR CONTROLLING BATTERY CHARGING, AND BATTERY SYSTEM INCLUDING SAME**

(30) Priority: 30.09.2024 KR 20240132493
(71) Applicant: LG Energy Solution, Ltd., Seoul 07335 (KR)
(72) Inventor: KIM, Taesoo, Daejeon 34122 (KR)
(74) Representative: Goddar, Heinz J.
(86) International application number: PCT/KR2025/013770
(87) International publication number: WO 2026/071551

(57) **Abstract**

A device and a method for controlling battery charging, and a battery system including same according to an embodiment and an experimental example of the present invention may monitor the state of charge (SOC) of a battery, control, on the basis of the SOC of the battery, the battery to be charged according to a first charging method, and control the battery to be charged according to a second charging method when the voltage value of the battery corresponds to the SOC of the battery and reaches a predefined charging voltage value while the battery is charged according to the first charging method.

## Description

### [Technical Field]

This application claims priority to and the benefit of Korean Patent Application No.10-2024-0132493 filed in the Korean Intellectual Property Office on September 30, 2024 the entire contents of which are incorporated herein by reference.

The present invention relates to an apparatus and method for controlling charge of a battery and a system including the apparatus and more particularly, to a battery charging control apparatus and method for controlling the size of a charging current for charging a battery based on the SOC of the battery and the voltage value of the battery, and to a battery system including the same.

### [Background Art]

With rising energy prices due to fossil fuel depletion and growing concerns about environmental pollution, demand for secondary batteries as an eco-friendly alternative energy source is rapidly increasing.

The secondary batteries, which can be repeatedly charged and recharged, are being used in a variety of applications from small devices like mobile phones and laptops to large-scale industrial applications such as automobiles, robots, and energy storage devices, as a response to today's environmental regulations and high oil prices.

Among secondary batteries, lithium secondary batteries are attracting attention due to their advantages over nickel-based batteries, including minimal memory effect, low self-discharge, and high energy density.

Conventionally, with the increasing use of lithium batteries, rapid charging technologies have been introduced to rapidly charge these batteries.

A rapid charging method of conventional technology uses a fast-charging map to obtain information on the size of the charging current for rapid charging based on the SOC of the battery to be charged, thereby fast charging the battery.

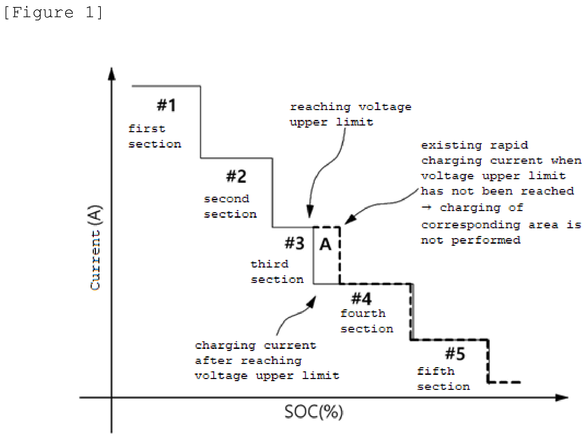

However, a conventional fast-charging map does not consider the voltage state of the battery to be charged, leading to battery degradation and reduced efficiency. Furthermore, as shown in Fig. 1, when charging the battery by temporarily lowering the charging current value only in a specific section (Nth section) to prevent battery deterioration, a disadvantage occurs in that the charging time increases and the charging efficiency decreases because the charging current equivalent to area A cannot be applied.

### [Detailed Description of the Invention]

### [Technical Problem]

To obviate one or more problems of the related art, embodiments of the present disclosure provide a battery charging control apparatus.

To obviate one or more problems of the related art, embodiments of the present disclosure also provide a battery charging control method.

To obviate one or more problems of the related art, embodiments of the present disclosure also provide a battery charging system.

### [Technical Solution]

In order to achieve the objective of the present disclosure, a battery charging control apparatus for controlling the charging of a battery may include at least one processor; and a memory configured to store at least one instruction executed by the at least one processor. Here, the at least one instruction may include an instruction to monitor a state of charge (SOC) of the battery; an instruction to control the battery to be charged according to a first charging method based on the SOC of the battery; and an instruction to control the battery to be charged according to a second charging method when a voltage value of the battery reaches a charging voltage value which is predefined corresponding to the SOC of the battery during the charging of the battery according to the first charging method.

Here, the instruction to control the battery to be charged according to the first charging method may include an instruction to identify an Nth section to which the SOC of the battery belongs using a charging current map in which charging current values for each SOC section are predefined; and an instruction to control the battery to be constant current charged with a charging current value corresponding to the Nth section.

Here, the instruction to control the battery to be charged according to the second charging method may include an instruction to identify a charging voltage value of the battery determined for the Nth section using a charging voltage map in which charging voltage values for each SOC section are predefined; an instruction to monitor the voltage value of the battery in the Nth section; and an instruction to control the battery to be charged with a constant voltage by switching to the second charging method when the voltage value of the battery reaches the charging voltage value determined for the Nth section so that the charging voltage value is maintained.

Meanwhile, the at least one instruction may further include an instruction to control the charging method of the battery to be switched to the first charging method and charging the battery, when the SOC section of the battery changes to the N+1 section during charging of the battery according to the second charging method.

Here, the charging current value corresponding to the N+1 section may be defined as a smaller value than the charging current value corresponding to the Nth section, based on the charging current map.

Meanwhile, the charging current map may further include charging current values predefined according to temperatures.

In addition, the instruction to control the battery to be charged according to the first charging method may include an instruction to identify an Nth section to which the SOC and temperature of the battery belong based on the charging current map; and an instruction to control the battery to be constant current charged with a charging current value corresponding to the Nth section.

Furthermore, the instruction to control the battery to be charged according to the second charging method may include an instruction to identify a charging voltage value corresponding to a specific section using a charging voltage map in which charging voltage values according to the SOC and temperature of the battery are predefined; an instruction to monitor the voltage value of the battery in the Nth section; and an instruction to control the battery to be charged with a constant voltage by switching to the second charging method, when the voltage value of the battery reaches the charging voltage value corresponding to a specific section so that the charging voltage value is maintained.

Furthermore, the at least one instruction may further include an instruction to control the charging of the battery by switching the charging method of the battery to the first charging method when a section to which the SOC and temperature of the battery belong changes during charging of the battery according to the second charging method.

According to another embodiment of the present disclosure, a battery charging control method for controlling the charging of a battery may include monitoring a state of charge (SOC) of the battery; controlling the battery to be charged according to a first charging method based on the SOC of the battery; and controlling the battery to be charged according to a second charging method when a voltage value of the battery reaches a charging voltage value which is predefined corresponding to the SOC of the battery while charging the battery according to the first charging method.

Here, the controlling of the battery to be charged according to the first charging method may include identifying an Nth section to which the SOC of the battery belongs using a charging current map in which charging current values for each SOC section are predefined; and controlling the battery to be constant current charged with a charging current value corresponding to the Nth section.

Here, the controlling of the battery to be charged according to the second charging method may include identifying a charging voltage value of the battery determined for the Nth section using a charging voltage map in which charging voltage values for each SOC section are predefined; monitoring the voltage value of the battery in the Nth section; and controlling the battery to be charged with a constant voltage by switching to the second charging method when the voltage value of the battery reaches the charging voltage value determined for the Nth section so that the charging voltage value is maintained.

Meanwhile, the method may further include controlling the charging method of the battery to be switched to the first charging method and charging the battery, when the SOC section of the battery changes to the N+1 section during charging of the battery according to the second charging method.

Here, the charging current value corresponding to the N+1 section may be defined as a smaller value than the charging current value corresponding to the Nth section, based on the charging current map.

Meanwhile, the charging current map may further include charging current values predefined according to temperatures.

In addition, the controlling of the battery to be charged according to the first charging method may include identifying an Nth section to which the SOC and temperature of the battery belong based on the charging current map; and controlling the battery to be constant current charged with a charging current value corresponding to the Nth section.

In addition, the controlling of the battery to be charged according to the second charging method may include identifying a charging voltage value corresponding to a specific section using a charging voltage map in which charging voltage values according to the SOC and temperature of the battery are predefined; monitoring the voltage value of the battery in the Nth section; and controlling the battery to be charged with a constant voltage by switching to the second charging method, when the voltage value of the battery reaches the charging voltage value corresponding to the specific section so that the charging voltage value is maintained.

Furthermore, the method may further include controlling the charging of the battery by switching the charging method of the battery to the first charging method when a section to which the SOC and temperature of the battery belong changes during charging of the battery according to the second charging method.

According to another embodiment of the present disclosure, a battery charging system may include a battery; a charging device that charges the battery by applying a charging current to the battery; and a battery charging control apparatus configured to control a size of a charging current provided by the charging device, wherein the battery charging control apparatus monitors a state of charge (SOC) of the battery, controls the battery to be charged according to a first charging method based on the SOC of the battery, and controls the battery to be charged according to a second charging method, when a voltage value of the battery corresponds to the SOC of the battery and reaches a predetermined charging voltage value while charging the battery according to the first charging method.

### [Advantageous Effects]

A battery charging control apparatus and method, and a battery system including the apparatus according to embodiments and experimental examples of the present disclosure, when charging of a battery that is being charged with a constant current charging for each SOC section of the battery, switches the charging method to the second charging method of constant voltage charging if a predetermined charging voltage value for the corresponding SOC section is reached, and thus can shorten the charging time and prevent lithium plating and degradation of the battery.

### [Brief Description of the Drawings]

FIG. 1 is a graph for explaining a typical battery charging control method.
FIG. 2 is a block diagram of a battery system to which embodiments of the present invention may be applied.
FIG. 3 is a block diagram of a battery charging system according to embodiments of the present invention.
FIG. 4 is a block diagram of a battery charging control apparatus according to embodiments of the present invention.
FIG. 5 is a flowchart illustrating a battery charging control method operated by a processor within a battery charging control apparatus according to an embodiment of the present invention.
FIG. 6 is an image of a charging current map according to an embodiment of the present invention.
FIG. 7 is an image of a charging voltage map according to an embodiment of the present invention.
FIG. 8 is a graph illustrating a battery charging control method based on the tables of FIGS. 6 and 7 according to embodiments of the present invention.
FIG. 9 is a graph comparing the charging times of batteries according to experimental examples of the present invention.
FIG. 10 is a flowchart illustrating a battery charging control method operated by a processor in a battery charging control apparatus according to another embodiment of the present invention.
FIG. 11 is an image of a charging current map according to another embodiment of the present invention.
FIG. 12 is an image of a charging voltage map according to another embodiment of the present invention.
FIG. 13 is a graph showing the capacity retention of batteries during a charge cycle according to an experimental example of the present invention.
   1000: battery
   3000: charging device
   5000: battery charging control apparatus
   100: memory
   200: processor
   300: transceiver
   400: input interface
   500: output interface
   600: storage device
   700: bus

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it may be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

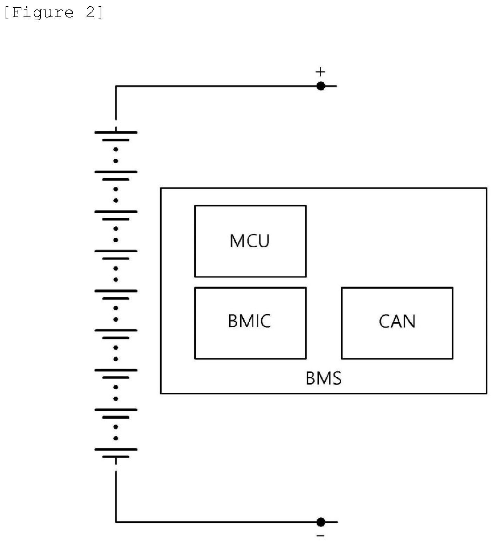

FIG. 2 is a block diagram of a battery system to which embodiments of the present invention may be applied.

Referring to FIG. 2, a battery may be configured to include a plurality of battery modules or cells connected in series. The battery cells or modules are connected to a load through positive and negative terminals and may perform charge and discharge operations. The most commonly used battery cells are lithium-ion (Li-Ion) battery cells.

These battery cells or modules may be linked to a battery management system (BMS).

The BMS may monitor the current, voltage, and temperature of each battery cell or module under its control, calculate the State of Charge (SOC) based on monitoring results, and control charging and discharging. Here, the State of Charge (SOC) represents the current state of charge of the battery as a percentage (%), while the State of Health (SOH) represents the current state of degradation of the battery as a percentage (%).

As such, the battery management system (BMS) monitors battery cells, reads cell voltages, and transmits these data to other systems connected to the battery.

Furthermore, the BMS may monitor at least one electrical component within the battery system and transmit these state data to other systems. For this, the BMS may include a communication module for communicating with other systems within a device included in the battery system.

The communication module of the BMS may communicate with other systems within the device using a Controller Area Network (CAN). Here, the electrical components, modules, or systems within the BMS are interconnected via a CAN bus. Accordingly, the BMS may remotely transmit state data acquired through monitoring of the battery pack or module and at least one electrical component within the BMS to other systems using CAN communication.

Meanwhile, the BMS evenly balances the charge of the battery cells to extend the life of the battery system.

To perform these operations, a battery management system (BMS) may include various components, such as fuses, current sensing elements, thermistors, switches, and balancers, and may, in most cases, additionally include an MCU (Micro Controller Unit) or BMIC (Battery Monitoring Integrated Chip) to interface with and control these components.

Meanwhile, a battery charging system according to embodiments of the present invention may be provided as a component of a battery management system (BMS) and may control rapid battery charging.

Hereinafter, preferred embodiments of the battery charging system according to the present invention will be described in detail with reference to the attached drawings.

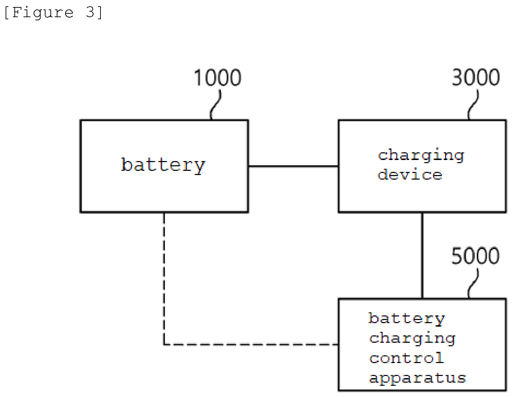

FIG. 3 is a block diagram of a battery charging system according to embodiments of the present invention.

Referring to FIG. 3, the battery charging system according to embodiments of the present invention may control rapid charging of a battery.

More specifically, the battery charging system may include a battery 1000, a charging device 3000, and a battery charging control apparatus 5000.

The battery 1000 may be provided in the form of a plurality of battery cells connected together. The battery 1000 may be connected to a charging device 3000, described below, and charged by a charging current applied from the charging device 3000. Here, the charging current may be adjusted and provided by the battery charging control apparatus 5000, described below, to a level that prevents lithium plating, taking into account the state of charge of the battery 1000.

The charging device 3000 may be electrically connected to the battery 1000 and charge the battery 1000. More specifically, the charging device 3000 may be electrically connected to the positive (+) and negative (-) terminals of the battery 1000, and charge the battery 1000.

Meanwhile, the charging device 3000 may be connected to a battery charging control apparatus 5000. According to an embodiment, the charging device 3000 may be connected to the battery charging control apparatus 5000 via CAN communication. Accordingly, the charging device 3000 may provide a charging current to the battery 1000 according to a charging current value received from the battery charging control apparatus 5000, as described above. In other words, the charging device 3000 may charge the battery 1000 by applying a charging current of a size determined by the battery charging control apparatus 5000 to the battery 1000.

The battery charging control apparatus 5000 may monitor the battery 1000 by receiving at least one piece of state information of the battery 1000. According to embodiments, the state information may include at least one piece of information from among the SOC, voltage (V), current (I), and temperature (T) of the battery 1000.

The battery charging control apparatus 5000 may obtain information on the upper limit values of the charging current provided for each section based on the state information of the battery 1000.

According to an embodiment, the battery charging control apparatus 5000 may obtain the upper limit current value in the section to which the SOC of the battery 1000 belongs by using a charging current map in which charging current values are predefined for each SOC section.

According to another embodiment, the battery charging control apparatus 5000 may obtain the upper limit current value in the section to which the SOC and temperature of the battery 1000 belong by using a charging current map in which charging current values are predefined for each SOC and temperature section.

Thereafter, the battery charging control apparatus 5000 may transmit the obtained charging current value to the charging device 3000 along with a first control signal. Here, the first control signal may be a signal that controls charging of the battery 1000 with a size of charging current corresponding to the charging current value according to the first charging method. Accordingly, the charging device 3000 may apply the size of charging current corresponding to the charging current value to the battery 1000 to charge the battery 1000 according to the first charging method. For example, the first charging method may be a constant current (CC) charging method.

Meanwhile, the battery charging control apparatus 5000 may acquire upper limit values of charging voltage provided for each section based on the state information of the battery 1000.

According to an embodiment, the battery charging control apparatus 5000 may obtain a charging voltage value in a section to which the SOC of the battery 1000 belongs, using a charging voltage map in which charging voltage values are predefined for each SOC section.

According to another embodiment, the battery charging control apparatus 5000 may obtain a charging voltage value in a section to which the SOC and temperature of the battery 1000 belong, using a charging voltage map in which charging voltage values are predefined for each SOC and temperature section.

Thereafter, the battery charging control apparatus 5000 may transmit the obtained charging voltage value to the charging device 3000 along with a second control signal. Here, the second control signal may be a signal that controls adjusting the size of the charging current of the battery 1000 according to the second charging method so that the charging voltage is maintained. Accordingly, the charging device 3000 may charge the battery 1000 with a constant voltage (CV) so that the battery maintains the charging voltage value by the second control signal.

Meanwhile, the battery charging control apparatus 5000 may control the battery 1000 to be charged according to the second charging method when the voltage value of the battery 1000 reaches a predefined charging voltage value corresponding to a specific section in the charging voltage map, during charging of the battery 1000 according to the first charging method in a specific section based on the state information of the battery 1000 using the charging current map. The charging current control method of the battery charging control apparatus 5000 will be described in more detail later when describing the battery charging control method.

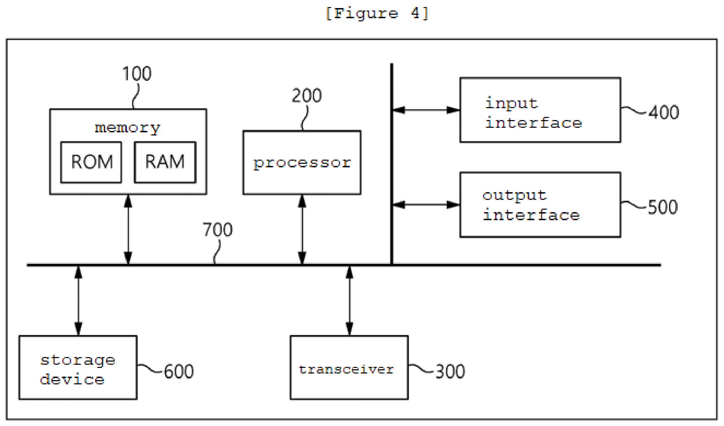

FIG. 4 is a block diagram of a battery charging control apparatus according to embodiments of the present invention.

Referring to FIG. 4, the battery charging control apparatus 5000 is described in more detail by component. The battery charging control apparatus 5000 may include a memory 100, a processor 200, a transceiver 300, an input interface device 400, an output interface device 500, and a storage device 600.

According to embodiments, each components 100, 200, 300, 400, 500, 600 included in the battery charging control apparatus 5000 may be connected via a bus 700 to communicate with each other.

Among the components 100, 200, 300, 400, 500, and 600, the memory 100 and the storage device 600 may be configured with at least one of a volatile storage medium and a non-volatile storage medium.

Furthermore, the memory 100 and the storage device 600 may be configured with at least one of a volatile/transitory storage medium and a non-volatile/non-transitory storage medium. For example, the memory 100 and the storage device 600 may be configured with at least one of a read-only memory (ROM) and a random access memory (RAM), and may include an Electrically Erasable Programmable Read-only Memory (EEPROM).

Among these, the memory 100 may include at least one instruction executed by the processor 200. According to embodiments, the at least one instruction may include an instruction to monitor a state of charge (SOC) of the battery; an instruction to control the battery to be charged according to a first charging method based on the SOC of the battery; and an instruction to control the battery to be charged according to a second charging method when a voltage value of the battery reaches a charging voltage value which is predefined corresponding to the SOC of the battery during the charging of the battery according to the first charging method.

Here, the instruction to control the battery to be charged according to the first charging method may include an instruction to identify an Nth section to which the SOC of the battery belongs using a charging current map in which charging current values for each SOC section are predefined; and an instruction to control the battery to be constant current charged with a charging current value corresponding to the Nth section.

Here, the instruction to control the battery to be charged according to the second charging method may include an instruction to identify a charging voltage value of the battery determined for the Nth section using a charging voltage map in which charging voltage values for each SOC section are predefined; an instruction to monitor the voltage value of the battery in the Nth section; and an instruction to control the battery to be charged with a constant voltage by switching to the second charging method when the voltage value of the battery reaches the charging voltage value determined for the Nth section so that the charging voltage value is maintained.

Meanwhile, the at least one instruction may further include an instruction to control the charging method of the battery to be switched to the first charging method and charging the battery, when the SOC section of the battery changes to the N+1 section during charging of the battery according to the second charging method.

Here, the charging current value corresponding to the N+1 section may be defined as a smaller value than the charging current value corresponding to the Nth section, based on the charging current map.

Meanwhile, the charging current map may further include charging current values predefined according to temperatures.

In addition, the instruction to control the battery to be charged according to the first charging method may include an instruction to identify an Nth section to which the SOC and temperature of the battery belong based on the charging current map; and an instruction to control the battery to be constant current charged with a charging current value corresponding to the Nth section.

Furthermore, the instruction to control the battery to be charged according to the second charging method may include an instruction to identify a charging voltage value corresponding to a specific section using a charging voltage map in which charging voltage values according to the SOC and temperature of the battery are predefined; an instruction to monitor the voltage value of the battery in the Nth section; and an instruction to control the battery to be charged with a constant voltage by switching to the second charging method, when the voltage value of the battery reaches the charging voltage value corresponding to the specific section so that the charging voltage value is maintained.

Furthermore, the at least one instruction may further include an instruction to control the charging of the battery by switching the charging method of the battery to the first charging method when a section to which the SOC and temperature of the battery belong changes during charging of the battery according to the second charging method.

Meanwhile, the processor 200 may refer to a central processing unit (CPU), a graphics processing unit (GPU), or a dedicated processor on which methods according to embodiments of the present invention are performed.

As previously described, the processor 200 may execute at least one program command stored in the memory 100.

The battery charging system including the battery charging control apparatus according to embodiments of the present invention has been described above. Below, a battery charging control method performed by the processor operation of the battery charging control apparatus according to embodiments of the present invention will be described in more detail.

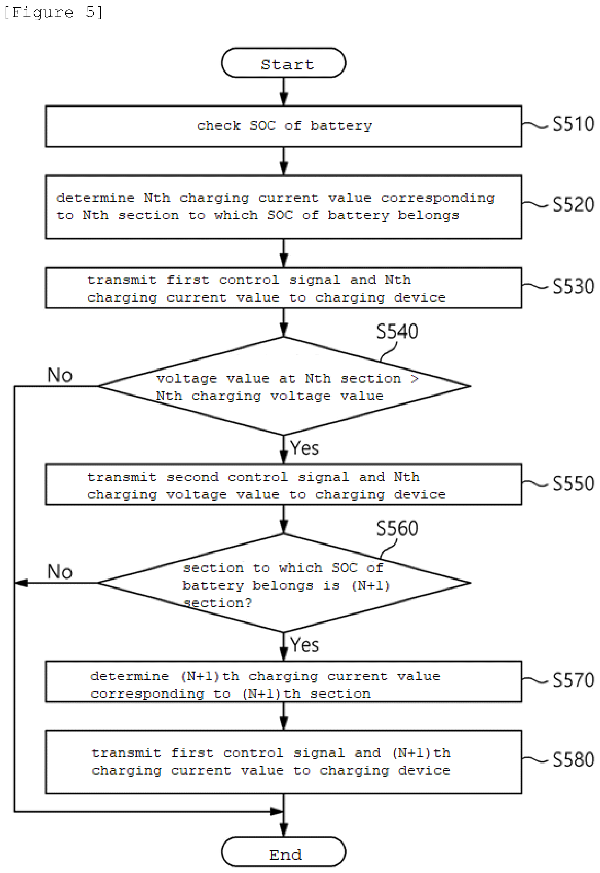

FIG. 5 is a flowchart illustrating a battery charging control method operated by a processor within a battery charging control apparatus according to an embodiment of the present invention.

Referring to FIG. 5, the battery charging control apparatus 5000 according to an embodiment of the present invention may check the SOC of the battery 1000 according to the operation of the processor 200 (S510).

According to an embodiment, the battery charging control apparatus 5000 may monitor the state information of the battery 1000 in real time and check the SOC.

According to another embodiment, the battery charging control apparatus 5000 may receive state information of the battery 1000 in real time from a separate monitoring device (not shown). Accordingly, the battery charging control apparatus 5000 may check the SOC of the battery 1000 among the state information received from the monitoring device.

Thereafter, the battery charging control apparatus 5000 may check the Nth section to which the SOC of the battery 1000 belongs and check the charging current value corresponding to the Nth section (S520).

According to an embodiment, the battery charging control apparatus 5000 may check the charging current value corresponding to the Nth section using a charging current map in which charging current values are predefined for each SOC section. The battery charging control apparatus 5000 may transmit a first control signal together with the Nth charging current value to the charging device 3000 (S530). Here, the first control signal may be a control signal for charging the battery 1000 with a size of charging current corresponding to the Nth charging current value according to the first charging method. Accordingly, the charging device 3000 may apply a charging current corresponding to the Nth charging current value to the battery 1000, thereby charging the battery 1000 according to the first charging method. Here, the first charging method may be a constant current (CC) charging method.

Thereafter, the battery charging control apparatus 5000 may monitor the voltage value of the battery 1000 in real time during the constant current (CC) charging of the battery 1000 according to the first charging method.

Here, when the voltage value of the battery 1000 reaches the Nth charging voltage value corresponding to the Nth section (S540), the battery charging control apparatus 5000 may transmit a second control signal together with the Nth charging voltage value to the charging device 3000 (S550). Here, the Nth charging voltage value may be obtained by checking the voltage value corresponding to the Nth section using a charging voltage map in which charging voltage values are predefined for each SOC section. In addition, the second control signal may be a signal for adjusting the charging current value of the battery so that the Nth charging voltage value corresponding to the Nth section is maintained according to a second charging method. Accordingly, the charging device 3000 may charge the battery with a constant voltage (CV) so that the battery maintains the Nth charging voltage value by the second control signal.

Thereafter, the battery charging control apparatus 5000 may monitor the SOC of the battery 1000 in real time during the constant voltage (CV) charging of the battery 1000 according to the second charging method.

Here, if the section to which the SOC of the battery 1000 belongs changes to the (N+1)th section (S560), the battery charging control apparatus 5000 may identify the upper limit current value corresponding to the (N+1)th section based on the charging current map (S570).

Thereafter, the battery charging control apparatus 5000 may transmit the (N+1)th charging current value and a first control signal to the charging device 3000 (S580). Here, the first control signal may be a signal that controls charging of the battery with a size of charging current corresponding to the (N+1)th charging current value according to the first charging method, as described above. Accordingly, the battery charging control apparatus 5000 may re-switch the charging method of the charging device 3000 from the second charging method, the constant voltage (CV) charging method, to the first charging method, the constant current (CC) charging method.

Thereafter, the battery charging control apparatus 5000 may repeatedly perform steps S540 to S580 until the SOC of the battery 1000 is fully charged.

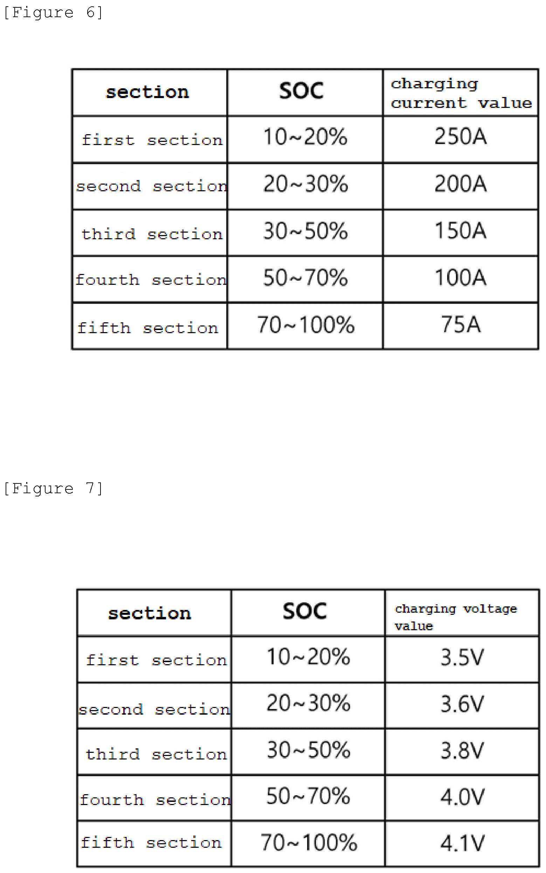

FIG. 6 is an image of a charging current map according to an embodiment of the present invention.

Referring to FIG. 6, the charging current map within a battery charging control apparatus according to embodiments of the present invention may be a table map in which charging current values are predefined for each SOC section.

According to an embodiment, in a first section, where the SOC is 10% or more but less than 20%, the charging current may be provided as 250 A.

Furthermore, in a second section, where the SOC is 20% or more but less than 30%, the charging current may be provided as 200 A.

Meanwhile, in a third section, where the SOC is 30% or more but less than 50%, the charging current may be provided as 150 A.

Furthermore, in a fourth section, where the SOC is 50% or more but less than 70%, the charging current may be provided as 100A.

Finally, in the fifth section, where the SOC is between 70% and 90%, the charging current may be set to 75 A.

In summary, the size of the charging current value in the charging current map may decrease as the SOC section increases. In other words, the battery charging control apparatus 5000 according to embodiments of the present invention can stably charge the battery 1000 by lowering the charging current as the SOC section increases to prevent lithium plating that occurs as the battery 1000 charges.

FIG. 7 is an image of a charging voltage map according to an embodiment of the present invention.

Referring to FIG. 7, the charging voltage map in the battery charging control apparatus according to an embodiment of the present invention may be a table map in which charging voltage values are predefined for each SOC section.

According to an embodiment, in the first section, where the SOC is 10% or more but less than 20%, the charging voltage value may be set to 3.5 V.

Additionally, in the second section, where the SOC is 20% or more but less than 30%, the charging voltage value may be set to 3.6 V.

In the third section, where the SOC is 30% or more but less than 50%, the charging voltage value may be set to 3.8 V.

In the fourth section, where the SOC is 50% or more but less than 70%, the charging voltage value may be set to 4.0 V.

Finally, in the fifth section, where the SOC is 70% or more but less than 90%, the charging voltage value may be set to 4.1 V.

In summary, the size of the charging voltage value in the charging current map may increase as the SOC section increases. In other words, the battery charging control apparatus 5000 according to embodiments of the present invention can stably charge the battery 1000 by maintaining a higher voltage as the SOC section increases to prevent degradation of the battery 1000.

Meanwhile, the charging current map and charging voltage map within the battery charging control apparatus may be stored and provided in a memory 100 or a storage device 600, and may be provided as a single charging map in which the charging current value and the charging voltage value are predefined for each section based on the SOC, without being limited to the disclosed one.

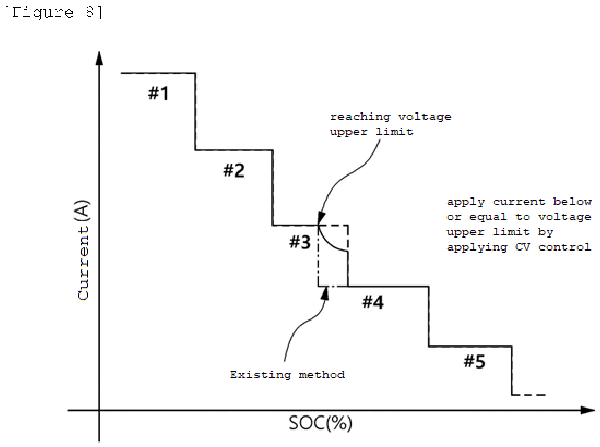

FIG. 8 is a graph illustrating a battery charging control method based on the tables of FIGS. 6 and 7 according to embodiments of the present invention.

Referring to FIG. 8, the battery charging control apparatus 5000 according to embodiments of the present invention may determine a charging current value to prevent lithium plating within a specific section (the Nth section) according to the real-time SOC of the battery based on the charging current map and charge the battery 1000 via the charging device 3000.

Thereafter, the battery charging control apparatus 5000 may monitor a real-time voltage measurement value of the battery 1000. If the real-time voltage measurement value of the battery 1000 exceeds a predefined charging voltage value of the corresponding section (the Nth section) according to the charging voltage map, the charging current value supplied from the charging device 3000 to the battery 1000 may be adjusted downward to prevent degradation of the battery 1000. Here, the battery charging control apparatus 5000 may adjust the charging current value supplied from the charging device 3000 so that the charging voltage value in the corresponding section is maintained.

More specifically, referring to FIGS. 6 to 8, when the real-time SOC of the battery 1000 is 15% and falls within the first section, the battery charging control apparatus may determine the charging current value of the battery 1000 as 250A which falls within the first section and transmit it to the charging device 3000 along with the first control signal. Accordingly, the battery 1000 may be charged at a constant current (CC) with a charging current of 250 A.

Thereafter, state information of the battery 1000 being charged at a constant current (CC) with a charging current of 250 A may be monitored. Here, if the voltage value of the battery 1000 is 3.4 V, which is lower than the voltage threshold value in the first section, while the SOC reaches 20% and enters the second section, the battery charge control apparatus 5000 may determine 200 A, which belongs to the second section, as the charging current value of the battery 1000, and transmit it to the charging device 3000 along with the first control signal. Accordingly, the battery 1000 may be charged with a constant current (CC) at a charging current of 100A.

Thereafter, the state information of the battery 1000 being charged with a constant current (CC) at a charging current of 200 A may be monitored. Here, if the voltage value of the battery 1000 is 3.6 V, which is lower than the voltage threshold value in the second section, while the SOC reaches 30% and enters the third section, the battery charge control apparatus 5000 may determine 150 A, which belongs to the third section, as the charging current value of the battery 1000, and transmit it to the charging device 3000 along with the first control signal. Accordingly, the battery 1000 may be charged with a constant current (CC) at a charging current of 150 A.

Thereafter, the state information of the battery 1000 being charged with a constant current (CC) at a charging current of 150 A may be monitored. Here, when the SOC is less than 50%, and the voltage value of the battery 1000 reaches 3.8 V, which is a charging voltage value corresponding to the third section, the battery charge control apparatus 5000 may transmit a second control signal to the charging device 3000 so that the voltage value of the battery 1000 is maintained at 3.8 V until the SOC of the battery 1000 reaches 50% which belongs to a fourth section. Accordingly, the battery 1000 may be charged with a constant voltage (CV) to maintain 3.8 V.

Thereafter, the state information of the battery 1000 being charged with a constant voltage (CV) may be monitored. Here, when the battery 1000 reaches 50%, the battery charge control apparatus 5000 may transmit a charging current value of 100A corresponding to the fourth section of the charging current map, along with a first control signal, to the charging device 3000. Accordingly, the battery 1000 may be charged with a constant current (CC) at a charging current of 100A.

Thereafter, state information of the battery 1000 being charged with a constant current (CC) at a charging current of 100A may be monitored. Here, if the voltage value of the battery 1000 is 3.9 V, which is still below the voltage threshold value in the fourth section, but the SOC reaches 70% and enters the fifth section, the battery charge control apparatus 5000 may determine 75 A, which belongs to the fifth section, as the charging current value of the battery 1000, and transmit it to the charging device 3000 along with the first control signal. Accordingly, the battery 1000 may be charged with a constant current (CC) at a charging current of 75 A.

Thereafter, the state information of the battery 1000 being charged with a constant current (CC) at a charging current of 75 A may be monitored. Here, when the SOC of the battery 1000 is fully charged (100%) or the voltage value of the battery 1000 reaches 4.1 V, which is the charging voltage value corresponding to the last fifth section, the battery charging control apparatus 5000 may transmit a charging termination signal to the charging device 3000. Accordingly, charging of the battery 1000 may be terminated.

In other words, the battery charging control apparatus 5000 may determine the charging current value stepwise based on the SOC of the battery 1000, as in the first section, the second section, and the fourth section, when the voltage value of the battery does not exceed the charging voltage value predefined for each section during constant current (CC) charging.

Meanwhile, the battery charge control apparatus 5000, as in the third section, may control the charging current flowing into the battery 1000 from the charging device 3000 to maintain the charging voltage value when the voltage of the battery 1000 reaches a predetermined charging voltage value in the corresponding section even though there is no change in the section based on the SOC of the battery during constant current (CC) charging, thereby performing constant voltage (CV) charging of the battery 1000.

Furthermore, as in the fifth section, which is the final section, the battery charge control apparatus 5000 may transmit a charging termination signal to the charging device 3000 when the battery 1000 is fully charged (SOC 100%) or the voltage of the battery 1000 exceeds the charging voltage value in the fifth section. Accordingly, charging of the battery 1000 may be terminated.

### Comparison of Charging Times of Batteries According to Experimental Examples of the Present Invention

A first battery, in its Beginning of Life (BOL) state, and a second battery that had undergone 460 charge-discharge cycles were prepared.

Here, the Capacity State of Health (SOHC) of the first and second batteries was measured to be 93.1%, and the Resistance State of Health (SOHR) was measured to be 0% (0.58 mΩ, 10 seconds).

The charging times of the first and second batteries according to their SOCs were then compared.

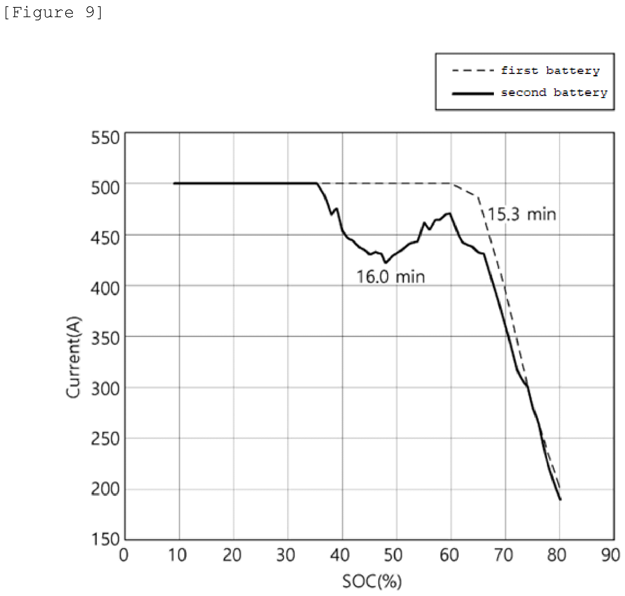

FIG. 9 is a graph comparing the charging times of batteries according to experimental examples of the present invention.

Referring to FIG. 9, the first and second batteries of their initial battery life (BOL) state, when charged at a constant current value based on the SOC, took 16 minutes to reach 80% of SOC.

Meanwhile, when charged using the battery charge control method according to an experimental example of the present invention, the first battery, in the initial battery life (BOL), took 15.3 minutes to reach 80% of its SOC, which is 0.7 seconds faster than when charged using the constant current charging method.

Furthermore, the second battery, which was charged and discharged up to 460 cycles using the battery charge control method according to an experimental example of the present invention, took 16 minutes to reach 80% of its SOC when charged using the constant current charging method, the same time as when charged as a battery in its initial battery life (BOL) using the constant current charging method. Therefore, the battery charging control method according to the embodiments and experimental examples of the present invention can shorten the charging time when charging a battery.

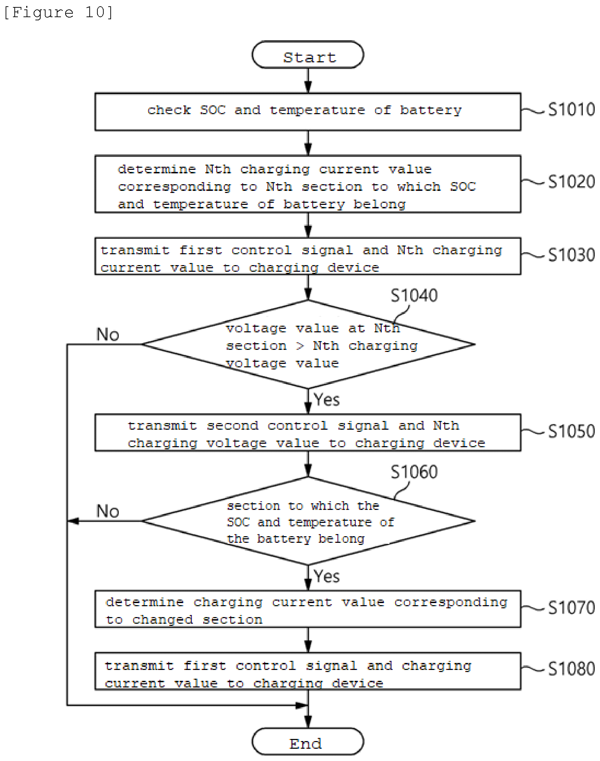

FIG. 10 is a flowchart illustrating a battery charging control method operated by a processor in a battery charging control apparatus according to another embodiment of the present invention.

Referring to FIG. 10, the battery charging control apparatus 5000 according to another embodiment of the present invention may check the SOC and temperature of the battery 1000 according to the operation of the processor 200 (S1010).

According to one embodiment, the battery charging control apparatus 5000 may monitor state information of the battery 1000 in real time and check the SOC and temperature.

According to another embodiment, the battery charging control apparatus 5000 may receive the state information of the battery 1000 in real time from a separate monitoring device (not shown). Accordingly, the battery charging control apparatus 5000 may check the SOC and temperature of the battery 1000 among the state information received from the monitoring device.

Thereafter, the battery charging control apparatus 5000 may identify a specific section to which the SOC and temperature of the battery 1000 belong and determine an Nth charging current value corresponding to the specific section (S1020).

Here, the battery charging control apparatus 5000 may identify an Nth charging current value corresponding to the specific section using a charging current map in which charging current values are predefined for each SOC and temperature section.

Thereafter, the battery charging control apparatus 5000 may transmit a first control signal along with the Nth charging current value to the charging device 3000 (S1030). Here, the first control signal may be a signal that controls charging of the battery 1000 at a charging current level corresponding to the Nth charging current value according to a first charging method. Accordingly, the charging device 3000 may apply a size of charging current corresponding to the Nth charging current value to the battery 1000, thereby charging the battery 1000 according to the first charging method. Here, the first charging method may be a constant current (CC) charging method.

Thereafter, the battery charging control apparatus 5000 may monitor the voltage value of the battery 1000 in real time during the constant current (CC) charging of the battery 1000 according to the first charging method.

Here, when the voltage value of the battery 1000 reaches the limit Nth charging voltage value corresponding to the specific section (S1040), the battery charging control apparatus 5000 may transmit a second control signal together with the Nth charging voltage value to the charging device 3000 (S1050).

Here, the Nth charging voltage value may be confirmed from a charging voltage map in which an upper limit of the charging voltage is predefined for each SOC and temperature section. In addition, the second control signal may be a signal for adjusting the charging current value of the battery so that the Nth charging voltage value corresponding to the specific section is maintained according to the second charging method. Accordingly, the charging device 3000 may charge the battery 1000 with a constant voltage (CV) so that the battery 1000 maintains the Nth charging voltage value by the second control signal.

Thereafter, the battery charging control apparatus 5000 may monitor the SOC of the battery 1000 in real time during the constant voltage (CV) charging of the battery 1000 according to the second charging method.

Here, if the section to which the SOC and temperature of the battery 1000 belong change from a specific section to another section (S1060), the battery charging control apparatus 5000 may determine the charging current value corresponding to the changed section based on the charging voltage map (S1070).

Thereafter, the battery charging control apparatus 5000 may transmit the charging current value and a first control signal to the charging device 3000 (S1080). Accordingly, the battery 1000 may be charged by switching from a constant voltage (CV) charging method to a constant current (CC) charging method.

Thereafter, the battery charging control apparatus 5000 may repeatedly perform steps S1040 to S1080 until the SOC of the battery 1000 is fully charged.

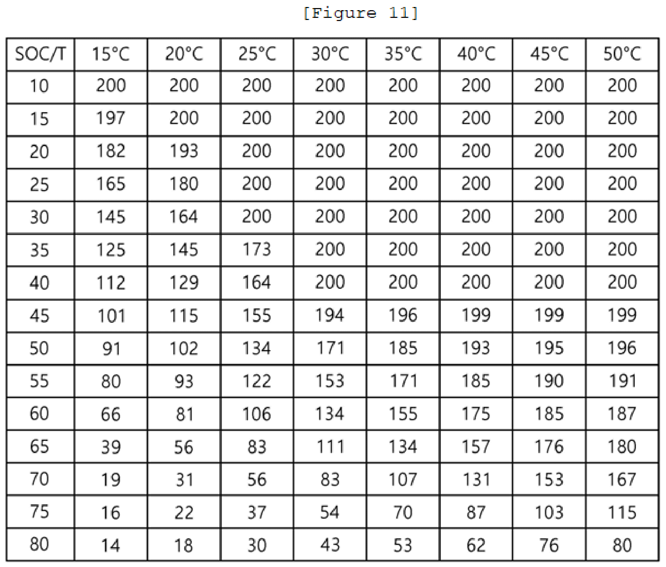

FIG. 11 is an image of a charging current map according to another embodiment of the present invention.

Referring to FIG. 11, the charging current map in a battery charging control apparatus 5000 according to another embodiment of the present invention may be provided as a two-dimensional table map, with charging current values predefined for each SOC and temperature range.

According to this embodiment, the charging current map may be defined to have a charging current value of 200 A as the upper limit and to have a higher charging current value as the temperature increases within the same SOC range and as the SOC decreases within the same temperature range.

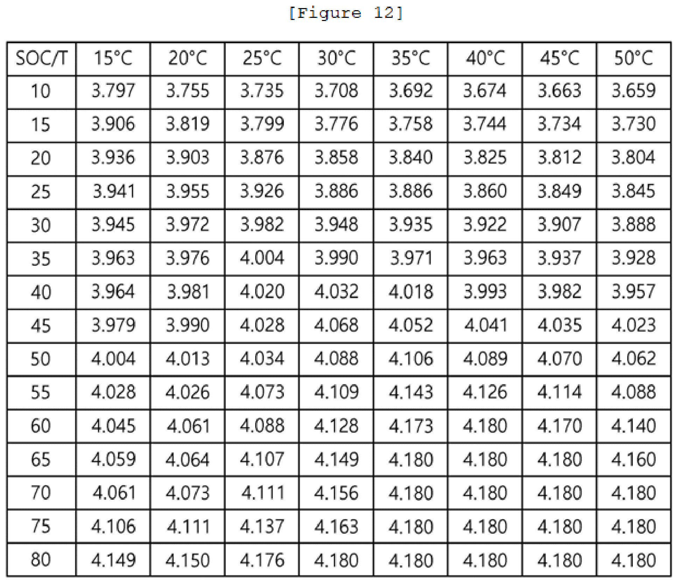

FIG. 12 is an image of a charging voltage map according to another embodiment of the present invention.

Referring to FIG. 12, the charging voltage map in a battery charging control apparatus 5000 according to another embodiment of the present invention may be provided as a two-dimensional table map, with charging voltage values predefined for each SOC and temperature range.

According to this embodiment, the charge voltage map may be defined to have a higher charge voltage value at higher temperatures within the same SOC range and at higher SOCs within the same temperature range.

### Performance Evaluation of Batteries According to Charge Control Methods

For performance evaluation of batteries, first to third batteries with different temperatures were prepared. The temperature of the first battery was measured at 55 degrees Celsius, the temperature of the second battery was measured at 65 degrees Celsius, and the temperature of the third battery was measured at 62 degrees Celsius.

Thereafter, charge and discharge cycles were performed on the first to third batteries. During the charge cycle, constant current (CC)-constant voltage (CV) charging according to the first and second charging methods was performed on the first and second batteries using the battery charge control method according to embodiments of the present invention, while constant current (CC) charging based on the charge current map was performed on the third battery.

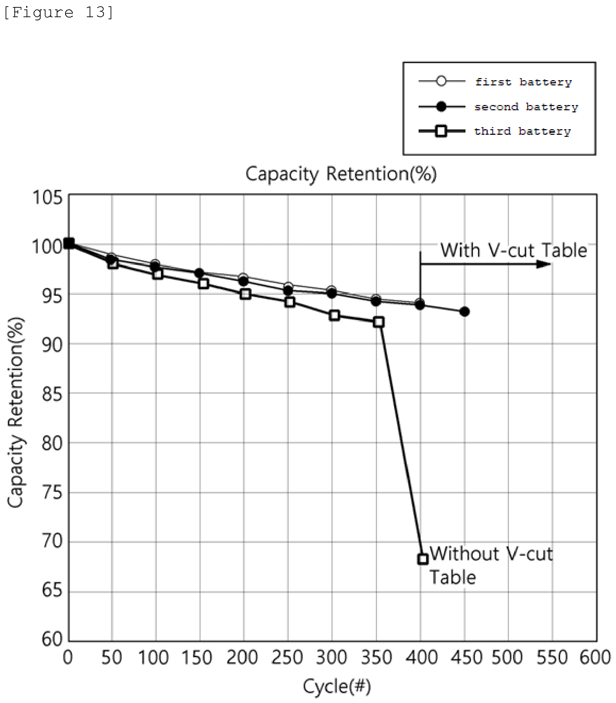

FIG. 13 is a graph showing the capacity retention of batteries during a charge cycle according to an experimental example of the present invention.

Referring to FIG. 13, based on the charge current map, the third battery, which was charged with constant current (CC), experienced a rapid capacity decrease at 350 cycles.

Meanwhile, the first and second batteries, which were charged using the battery charge control method according to embodiments of the present invention, were confirmed to maintain capacities of over 90% for 400 and 450 cycles, respectively.

In the foregoing, the battery charge control apparatus and method according to the embodiments and experimental examples of the present invention, and the battery system including the same, have been described.

The battery charge control apparatus and method according to the embodiments and experimental examples of the present invention, and the battery system including the same, perform constant current charging at a charge current corresponding to an SOC section of the battery during charging. Subsequently, when the voltage of the battery reaches a charge voltage value corresponding to the SOC section during constant current charging, the battery is controlled to be charged at a constant voltage so that the charge voltage value is maintained, which prevents lithium plating and battery degradation due to rapid charging, while also reducing the charging time.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

The operations of the method according to embodiments of the present invention may be implemented in various forms related to programs, such as a computer program or code itself, or a computer program product.

Furthermore, the computer-readable recording medium may include one or more of a volatile/transitory recording medium and a non-volatile/non-transitory recording medium.

In addition, the computer-readable recording medium may include hardware devices specially configured to store and execute program instructions, such as ROM, RAM, flash memory, and may include, for example, various types of servers located on a network. The program instructions may include not only machine language codes, such as those created by a compiler, but also high-level language codes that may be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. An apparatus for controlling the charging of a battery, the apparatus comprising:
at least one processor; and
a memory configured to store at least one instruction executed by the at least one processor,
wherein the at least one instruction includes:
an instruction to monitor a SOC of the battery;
an instruction to control the battery to be charged according to a first charging method based on the SOC of the battery; and
an instruction to control the battery to be charged according to a second charging method when a voltage value of the battery reaches a charging voltage value which is predefined corresponding to the SOC of the battery during the charging of the battery according to the first charging method.

2. The apparatus of claim 1, wherein the instruction to control the battery to be charged according to the first charging method includes:
an instruction to identify an Nth section to which the SOC of the battery belongs using a charging current map in which charging current values for each SOC section are predefined; and
an instruction to control the battery to be constant current charged with a charging current value corresponding to the Nth section.

3. The apparatus of claim 2, wherein the instruction to control the battery to be charged according to the second charging method includes:
an instruction to identify a charging voltage value of the battery determined for the Nth section using a charging voltage map in which charging voltage values for each SOC section are predefined;
an instruction to monitor the voltage value of the battery in the Nth section; and
an instruction to control the battery to be charged with a constant voltage by switching to the second charging method when the voltage value of the battery reaches the charging voltage value determined for the Nth section so that the charging voltage value is maintained.

4. The apparatus of claim 1, wherein the at least one instruction further includes:
an instruction to control the charging method of the battery to be switched to the first charging method and charging the battery, when the SOC section of the battery changes to the N+1 section during charging of the battery according to the second charging method.

5. The apparatus of claim 4, wherein the charging current value corresponding to the N+1 section is defined as a smaller value than the charging current value corresponding to the Nth section, based on the charging current map.

6. The apparatus of claim 2, wherein the charging current map further includes charging current values predefined according to temperatures.

7. The apparatus of claim 6, wherein the instruction to control the battery to be charged according to the first charging method includes:
an instruction to identify an Nth section to which the SOC and temperature of the battery belong based on the charging current map; and
an instruction to control the battery to be constant current charged with a charging current value corresponding to the Nth section.

8. The apparatus of claim 6, wherein the instruction to control the battery to be charged according to the second charging method includes:
an instruction to identify a charging voltage value corresponding to a specific section using a charging voltage map in which charging voltage values according to the SOC and temperature of the battery are predefined;
an instruction to monitor the voltage value of the battery in the Nth section; and
an instruction to control the battery to be charged with a constant voltage by switching to the second charging method, when the voltage value of the battery reaches the charging voltage value corresponding to the specific section so that the charging voltage value is maintained.

9. The apparatus of claim 1, wherein the at least one instruction further includes:
an instruction to control the charging of the battery by switching the charging method of the battery to the first charging method when a section to which the SOC and temperature of the battery belong changes during charging of the battery according to the second charging method.

10. A method for controlling the charging of a battery, the method comprising:
monitoring a SOC of the battery;
controlling the battery to be charged according to a first charging method based on the SOC of the battery; and
controlling the battery to be charged according to a second charging method when a voltage value of the battery reaches a charging voltage value which is predefined corresponding to the SOC of the battery while charging the battery according to the first charging method.

11. The method of claim 10, wherein the controlling of the battery to be charged according to the first charging method includes:
identifying an Nth section to which the SOC of the battery belongs using a charging current map in which charging current values for each SOC section are predefined; and
controlling the battery to be constant current charged with a charging current value corresponding to the Nth section.

12. The method of claim 11, wherein the controlling of the battery to be charged according to the second charging method includes:
identifying a charging voltage value of the battery determined for the Nth section using a charging voltage map in which charging voltage values for each SOC section are predefined;
monitoring the voltage value of the battery in the Nth section; and
controlling the battery to be charged with a constant voltage by switching to the second charging method when the voltage value of the battery reaches the charging voltage value determined for the Nth section so that the charging voltage value is maintained.

13. The method of claim 10, further comprising:
controlling the charging method of the battery to be switched to the first charging method and charging the battery, when the SOC section of the battery changes to the N+1 section during charging of the battery according to the second charging method.

14. The method of claim 13, wherein the charging current value corresponding to the N+1 section is defined as a smaller value than the charging current value corresponding to the Nth section, based on the charging current map.

15. The method of claim 11, wherein the charging current map further includes charging current values predefined according to temperatures.

16. The method of claim 15, wherein the controlling of the battery to be charged according to the first charging method includes:
identifying an Nth section to which the SOC and temperature of the battery belong based on the charging current map; and
controlling the battery to be constant current charged with a charging current value corresponding to the Nth section.

17. The method of claim 15, the controlling of the battery to be charged according to the second charging method includes:
identifying a charging voltage value corresponding to a specific section using a charging voltage map in which charging voltage values according to the SOC and temperature of the battery are predefined;
monitoring the voltage value of the battery in the Nth section; and
controlling the battery to be charged with a constant voltage by switching to the second charging method, when the voltage value of the battery reaches the charging voltage value corresponding to the specific section so that the charging voltage value is maintained.

18. The method of claim 10, further comprising:
controlling the charging of the battery by switching the charging method of the battery to the first charging method when a section to which the SOC and temperature of the battery belong changes during charging of the battery according to the second charging method.

19. A battery charging system comprising:
a battery;
a charging device that charges the battery by applying a charging current to the battery; and
a apparatus configured to control a size of a charging current provided by the charging device,
wherein the apparatus monitors a SOC of the battery, controls the battery to be charged according to a first charging method based on the SOC of the battery, and controls the battery to be charged according to a second charging method, when a voltage value of the battery corresponds to the SOC of the battery and reaches a predetermined charging voltage value while charging the battery according to the first charging method.

20. A computer-readable medium having recorded thereon a program for executing the method according to any one of claims 10 to 18 on a computer.
